Europäisches Patentamt

(19) European Patent Office

Office européen des brevets

(11) Veröffentlichungsnummer: **0 032 694**
**B1**

(12) # EUROPÄISCHE PATENTSCHRIFT

(45) Veröffentlichungstag der Patentschrift:
09.05.84

(21) Anmeldenummer: 81100129.6

(22) Anmeldetag: 09.01.81

(51) Int. Cl.³: **G 01 R 31/02, H 01 H 9/16,**
**H 02 J 13/00**

(54) **Anordnung zur Ermittlung der Schaltstellung eines Schalters und zur Überwachung der zugehörigen Leitung auf Kurzschluss und Unterbrechung.**

(30) Priorität: 21.01.80 DE 3001940

(43) Veröffentlichungstag der Anmeldung:
29.07.81 Patentblatt 81/30

(45) Bekanntmachung des Hinweises auf die Patenterteilung:
09.05.84 Patentblatt 84/19

(84) Benannte Vertragsstaaten:
BE CH DE GB LI

(56) Entgegenhaltungen:
DE - A - 2 641 079
DE - A - 2 703 560
FR - A - 2 151 787

TECHNICAL DIGEST - WESTERN ELECTRIC, Nr. 43, Juli 1976, Seite 7 New York, U.S.A. F.W. BECKMAN: "Diode test circuit"

(73) Patentinhaber: SIEMENS AKTIENGESELLSCHAFT,
Berlin und München Wittelsbacherplatz 2,
D-8000 München 2 (DE)

(72) Erfinder: Heidemann, Lüder, Dipl.-Ing., Bonhoeffer Weg 11, D-8520 Erlangen (DE)

**Beschreibung**

Die Erfindung betrifft eine Anordnung zur Ermittlung der Schaltstellung eines Meldeschalters und zur Überwachung der an den Schalter angeschlossenen zweiadrigen Leitung auf Kurzschluss und Unterbrechung, mit einer Auswerteanordnung, die einen Generator zur Erzeugung einer Prüfspannung oder eines Prüfstromes mit periodisch wechselnder Amplitude und mit endlicher Flankensteilheit und eine Triggerschaltung enthält und die je ein die Schaltstellung und ein eine Leitungsstörung anzeigendes Signal liefert.

Eine derartige Anordnung, die mit einer trapezförmigen Prüfspannung arbeitet, ist aus der FR-PS 2 151 787 bekannt. Für die Auswertung ist der konstant verlaufende positive und negative Anteil der Prüfspannung entscheidend. Zur Feststellung der Schaltstellung eines Schalters ist hier eine Ausführung des Schalters als Wechsler erforderlich, in dessen von der Schaltstellung abhängigen Strompfaden je ein Gleichrichterelement angeordnet ist. Diese Gleichrichterelemente sind antiparallel geschaltet, so dass die Auswerteanordnung, die monostabile Speicher (Triggerschaltungen) und Koinzidenzgatter enthält, die Stromrichtung als Kriterium für die Schaltstellung und die Zustände «Strom in beiden Richtungen» oder «Kein Strom» als Kriterium für einen Leitungskurzschluss bzw. für eine Unterbrechung der Leitung auswertet.

Die Verwendung eines Wechslers als Schalter bedeutet häufig einen zusätzlichen Aufwand, da für Meldezwecke vorgesehene Hilfsschalter an Schaltgeräten und Relais in der Regel als Öffner oder Schliesser ausgeführt sind.

Zur Prüfung von Dioden auf ihre Funktionsfähigkeit ist ferner eine Schaltung bekannt, die einen Generator zur Erzeugung einer Prüfspannung periodischer Funktion mit endlicher Flankensteilheit, eine Triggerschaltung zur Auswertung der Ausgangssignale einer mit einer Diode und zwei Widerständen in Reihe geschalteten Zenerdiode und eine aus zwei Lampen bestehende Anzeigevorrichtung enthält (Technical digest - Western Electric, Nr. 43, Juli 1976, Seite 7). Die zu prüfende Diode ist der die Zenerdiode enthaltenden Reihenschaltung parallel geschaltet. Arbeitet diese Diode einwandfrei, leuchten die Anzeigelampen abwechselnd im Takt der Prüfspannung. Schliesst die Diode aufgrund eines inneren Kurzschlusses die Reihenschaltung kurz, dann leuchten die Anzeigelampen gleichzeitig. Ist die Diode defekt im Sinne einer Unterbrechung der Prüfleitung, so leuchtet nur die mit der Triggerschaltung in Reihe liegende Anzeigelampe. Einer Diode mit innerem Kurzschluss entspricht ein Kurzschluss auf der Prüfleitung. Es ist daher nicht möglich, einen Kurzschluss auf der oder eine Unterbrechung der Prüfleitung von dem entsprechenden Defekt der Diode zu unterscheiden.

Der Erfindung liegt die Aufgabe zugrunde, eine Anordnung zu schaffen, die mit einfachen Mitteln eine Anzeige der Schaltstellung nicht nur eines Wechslers, sondern auch eines Schliessers oder Öffners sowie eines Kurzschlusses oder einer Leitungsunterbrechung ermöglicht, ohne dass dazu die Stromrichtung des Generators als Kriterium für die Auswetung herangezogen werden muss (siehe Figuren und entsprechende Beschreibung).

Gemäss der Erfindung wird diese Aufgabe bei einer Anordnung der eingangs genannten Art dadurch gelöst, dass die Prüfspannung bzw. der Prüfstrom des Generators im wesentlichen dreieckförmig ist, dass dem als Wechsler, Öffner oder Schliesser ausgeführten Schalter ein Grenzwertglied zugeordnet ist, an dem von der Schalterstellung und vom Leitungszustand abhängige erste unterschiedliche Spannungswerte auftreten, und dass die Triggerschaltung zweite, von den ersten unterschiedlichen Spannungswerten des Grenzgliedes abgeleitete Spanungswerte in Impulse entsprechend unterschiedlicher Dauer umsetzt.

An in der Zeichnung dargestellten Ausführungsbeispielen wird die Erfindung im folgenden näher erläutert. Es zeigen:

Fig. 1 ein Ausführungsbeispiel der Überwachungsanordnung mit einem Schalter in Ausführung, als Schliesser oder wahlweise als Öffner und zugehörigem Grenzwertglied,

Fig. 2 einen anderen Aufbau des Grenzwertgliedes,

Fig. 3 den Aufbau des Grenzwertgliedes für einen Schalter in Ausführung als Wechsler,

Fig. 4 den Verlauf der aus einer Prüfspannung abgeleiteten Ausgangssignale des Grenzwertgliedes nach Fig. 1,

Fig. 5 ein weiteres Ausführungsbeispiel der Überwachungsanordnung.

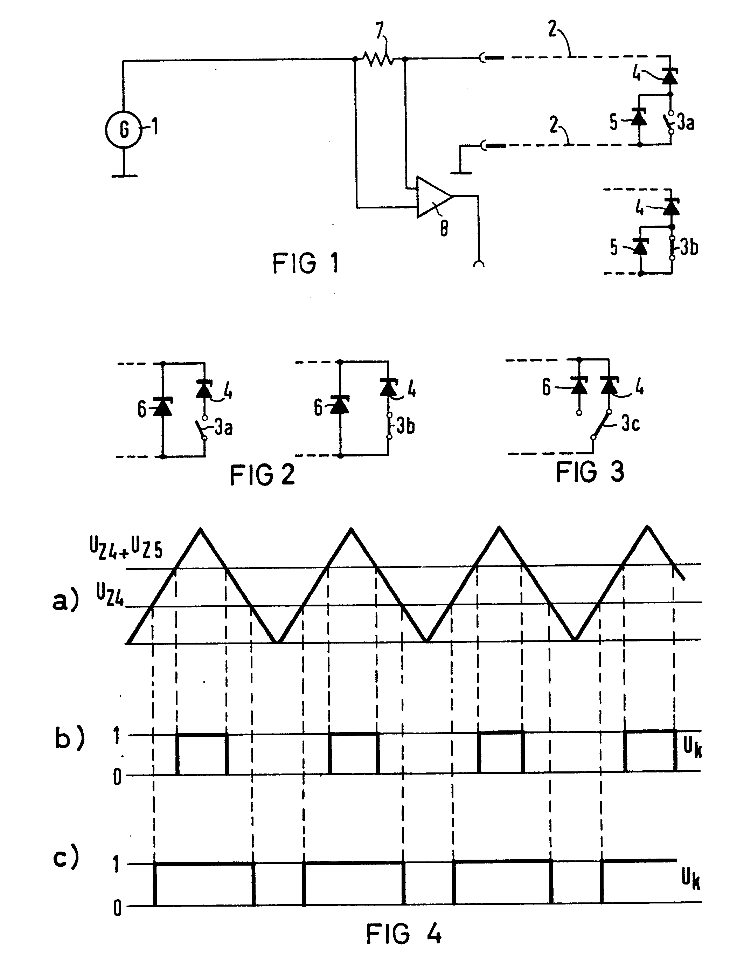

Wie Fig. 1 in Zusammenhang mit Fig. 4 zeigt, liefert ein Generator 1 eine Spannung oder einen Strom mit periodisch wechselnder Amplitude und endlicher Flankensteilheit, und zwar eine Spannung oder einen Strom mit dreieckförmigem Verlauf. Eine Leitung 2 verbindet den Generator mit einem beispielsweise als Schliesser ausgeführten Schalter 3a, der mit einer Zenerdiode 4 in Reihe geschaltet und durch eine weitere Zenerdiode 5 überbrückt ist. Die Schwellspannungen der Zenerdioden 4 und 5 sind gleich gross. Dieser Schaltungsaufbau ändert sich nicht, wenn anstelle der Schliessers ein Öffner 3b verwendet wird.

Wie Fig. 2 zeigt, kann anstelle einer Überbrückung des Schalters durch die Zenerdiode 5 auch die Reihenschaltung aus dem Schliesser 3a oder dem Öffner 3b und der Zenerdiode 4 durch eine Zenerdiode 6 überbrückt werden. In diesem Falle ist die Schwellspannung der Zenerdiode 6 höher zu wählen als die der Zenerdiode 4, beispielsweise doppelt so hoch. Die Grösse der Zenerspannungen gilt auch für den Fall, dass als Schalter ein Wechsler 3c verwendet wird (Fig. 3).

An einem im Zuge der Leitung 2 angeordneten Widerstand 7 ist eine Triggerschaltung 8 angeschlossen. Das Ausgangssignal der Triggerschaltung nimmt je nach Schaltstellung des Schalters oder entsprechend dem Zustand der Leitung den in den Fig. 4b und 4c dargestellten Verlauf an. Der von den Schaltstellungen abhängige Verlauf der Ausgangsspannung der Triggerschaltung 8 ergibt sich aus der in Fig. 4a gezeigten, vom Generator 1 gelieferten Prüfspannung und den Schwellspannungen $u_{z4}$ bzw. $u_{z4} + u_{z5}$ der Zenerdioden, wobei die am Widerstand 7 resultierenden Spannungswerte von der Triggerschaltung in Impulse entsprechender Dauer umgesetzt werden, wie in Fig. 4b und 4c dargestellt ist. Wenn die Schwellspannung der Zenerdiode 6 entsprechend Fig. 4a doppelt so gross gewählt wird wie die der Zenerdiode 4, entspricht sie der Summe aus den Zenerspannungen $u_{z4} + u_{z5}$. Die in Fig. 4b dargestellten Ausgangsimpulse der Triggerschaltung ergeben sich, wenn der Schalter geöffnet ist, die Ausgangsimpulse nach Fig. 4c, wenn der Schalter geschlossen ist. Im Falle eines Kurzschlusses verläuft das Ausgangssignal entsprechend der mit $u_k$ bezeichneten Linie (1-Signal). Ist die Leitung unterbrochen, dann ist das Ausgangssignal der Triggerschaltung 0. Zur weiteren Auswertung können beispielsweise Zeitglieder verwendet werden.

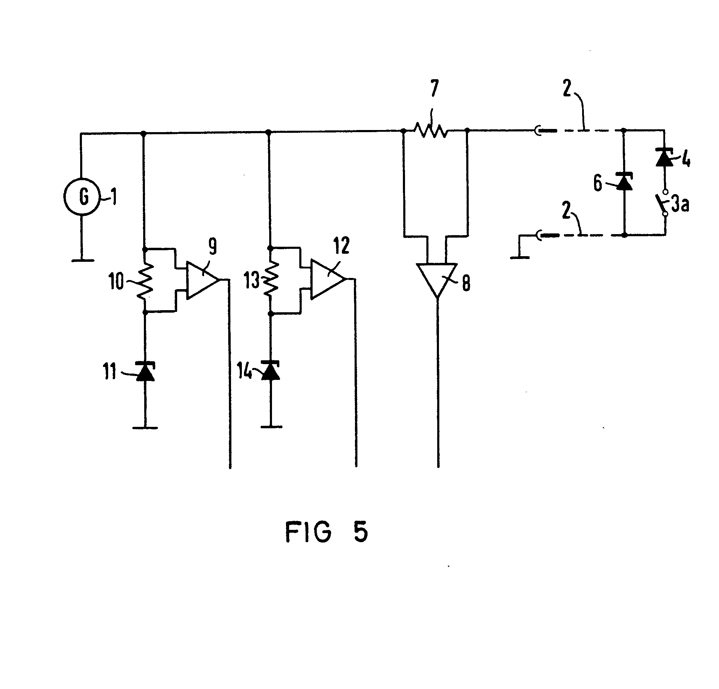

In Fig. 5 ist ein weiteres Ausführungsbeispiel der Erfindung dargestellt, das sich von der Ausführung nach Fig. 1 durch zwei zusätzliche Triggerschaltungen 9, 12 unterscheidet. Die Triggerschaltung 9 ist an einen Widerstand 10 angeschlossen und bildet mit einer Zenerdiode 11 eine an der Prüfspannung liegende Reihenschaltung. In gleicher Weise ist aus einer Zenerdiode 14 und einem Widerstand 13, an dem die Triggerschaltung 12 angeschlossen ist, eine Reihenschaltung gebildet. Die Schwellspannung der Zenerdiode 11 entspricht beispielsweise der Schwellspannung der Zenerdiode 4 und die Schwellspannung der Zenerdiode 14 entspricht beisielsweise der Schwellspannung der Zenerdiode 6 bzw. der Summe aus den Schwellspannungen der Zenerdioden 4 und 5. Zur weiteren Auswertung sind die Ausgangssignale der Triggerschaltungen 8, 9 und 12 beispielsweise einem Exclusiv-Odergatter zugeführt.

Nach Fig. 4a verläuft die Prüfspannung nur im positiven Bereich. Wenn die Prüfspannung auch einen negativen Anteil hat, lässt sich dieser für Rückmeldezwecke auswerten.

**Patentansprüche**

1. Anordnung zur Ermittlung der Schaltstellung eines Meldeschalters (3a-c) und zur Überwachung der an den Schalter (3a-c) angeschlossenen zweiadrigen Leitung (2) auf Kurzschluss und Unterbrechung, mit einer Auswerteanordnung, die einen Generator (1) zur Erzeugung einer Prüfspannung oder eines Prüfstromes mit periodisch wechselnder Amplitude und mit endlicher Flankensteilheit und eine Triggerschaltung (8) enthält und die je ein die Schaltstellung und ein eine Leitungsstörung anzeigendes Signal liefert, dadurch gekennzeichnet, dass die Prüfspannung bzw. der Prüfstrom des Generators (1) im wesentlichen dreieckförmig ist, dass dem als Wechsler, Öffner oder Schliesser ausgeführten Schalter (3) ein Grenzwertglied (4, 5 oder 4, 6) zugeordnet ist, an dem von der Schalterstellung und vom Leitungszustand abhängige erste unterschiedliche Spannungswerte auftreten, und dass die Triggerschaltung (8) zweite, von den ersten unterschiedlichen Spanungswerten des Grenzwertgliedes abgeleitete Spannungswerte in Impulse entsprechend unterschiedlicher Dauer umsetzt.

2. Anordnung nach Anspruch 1, dadurch gekennzeichnet, dass das Grenzwertglied zwei bezüglich des Generators in Serie geschaltete Zenerdioden (4, 5) aufweist, wobei die eine Zenerdiode (4) mit dem als Öffner (3b) oder Schliesser (3a) ausgeführten Schalter eine Reihenschaltung bildet und die andere Zenerdiode (5) mit derselben Zenerspannung wie die der einen Zenerdiode (4) den Schalter überbrückt.

3. Anordnung nach Anspruch 1, dadurch gekennzeichnet, dass das Grenzwertglied zwei Zenerdioden (4, 6) aufweist, wobei die eine Zenerdiode (4) mit dem als Öffner (3b) oder Schliesser (3a) ausgeführten Schalter eine Reihenschaltung bildet und die andere Zenerdiode (6) mit höherer Zenerspannung als die der einen Zenerdiode (4) der Reihenschaltung parallel geschaltet ist.

4. Anordnung nach Anspruch 1, dadurch gekennzeichnet, dass das Grenzwertglied zwei Zenerdioden (4, 6) aufweist und der Schalter als Wechsler (3c) ausgeführt ist und in der einen Schaltstellung mit der einen Zenerdiode (6) und in der anderen Schaltstellung mit der anderen Zenerdiode (4) eine Reihenschaltung bildet, wobei die Zenerspannung der einen in dem einen Strompfad des Wechslers (3c) angeordneten Zenerdiode (6) höher als die der anderen in dem anderen Strompfad angeordneten Zenerdiode (4) ist.

5. Anordnung nach einem der Ansprüche 3 oder 4, dadurch gekennzeichnet, dass an den Generator zwei weitere Reihenschaltungen aus je einer weiteren Zenerdiode (11, 14) und je einem Widerstand (10, 13), dem je eine weitere Triggerschaltung (9 bzw. 12) parallel geschaltet ist, angeschlossen sind, und die Zenerspannung der einen weiteren Zenerdiode (11) der einen weiteren Reihenschaltung der Zenerspannung der einen Zenerdiode (4) des Grenzwertgliedes und die Zenerspannung der anderen weiteren Zenerdiode (14) der anderen weiteren Reihenschaltung der Zenerspannung der anderen Zenerdiode (6) des Grenzwertgliedes entspricht.

**Claims**

1. Arrangement to determine the state of a reporting switch (3a-c) and to monitor the two-wire line (2) connected to the switch (3a-c) for short-circuit and interruption, having an evaluationg arrangement which comprises a trigger circuit (8) and a generator (1) for producing a test voltage or a test current with a periodically changing amplitude and with a steep trailing edge, and which supplies in each case one signal indicating the switch position and one indicating a line disturbance, characterised in that the test voltage or the test current of the generator (1) is substantially triangular, in that there is associated with the switch (3) designed as a changer, opener or closer, a threshold value member (4, 5 or 4, 6), at which first variable voltage values dependent on the switch position and the state of the liner occur, and in that the trigger circuit (8) converts second voltage values derived from the first variable voltage values of the threshold value member into impulses of a correspondingly variable duration.

2. Arrangement according to claim 1, characterised in that the threshold value member comprises two Zener diodes (4, 5) connected in series relative to the generator, one Zener diode (4) forming a series connection with the switch designed as an opener (3b) or closer (3a), and the other Zener diode (5) bridging the switch with the same Zener voltages as that of the first Zener diode (4).

3. Arrangement according to claim 1, characterised in that the threshold value member comprising two Zener diodes (4, 6), one Zener diode (4) forming a series connection with the switch designed as an opener (3b) or closer (3a), and the other Zener diode (6) being connected in parallel with the series connection, with a higher Zener voltage than that of the first Zener diode (4).

4. Arrangement according to claim 1, characterised in that the threshold value member comprises two Zener diodes (4, 6) and the switch is designed as a changer (3c), and forms a series connection in one switch position with one Zener diode (6), and in the other switch position with the other Zener diode (4), the Zener voltage of the one Zener diode (6) arranged in one current path of the changer (3c) being higher than that of the other Zener diode (4) arranged in the other current path.

5. Arrangement according to one of the claims 3 or 4, characterised in that two further series connections, each comprising one further Zener diode (11, 14) and one resistor (10, 13), to which resistor a further trigger circuit (9, 12) in each case is connected in parallel, are connected to the generator, and the Zener voltage of the one further Zener diode (11) of one further series connection corresponds to the Zener voltage of one Zener diode (4) of the threshold value member, and the Zener voltage of the other further Zener diode (14) of the other further series connection corresponding to the Zener voltage of the other Zener diode (6) of the threshold value member.

**Revendications**

1. Dispositif pour déterminer la position de commutation d'un interrupteur de signalisation (3a-c) et pour surveiller, du point de vue d'un court-circuit ou d'une coupure, le conducteur bifilaire (2) relié au commutateur (3a-c), avec un dispositif d'évaluation comportant un générateur (1) pour produire une tension d'essai ou un courant d'essai d'amplitude à changement périodique, et à flanc à pente finie, et un circuit de déclenchement (8), et qui fournit des signaux indiquant respectivement la position de commutation et un défaut du conducteur, caractérisé par le fait que la tension d'essai ou le courant d'essai du générateur (1) est essentiellement de forme triangulaire, qu'au contacteur (3) réalisé sous la forme d'un interrupteur-inverseur, d'un interrupteur de rupture ou d'un interrupteur de fermeture, est associé un dispositif à valeur-limite (4, 5 ou 4, 6) au niveau duquel apparaissent des premières valeurs différentes de tension, en fonction de la position de l'interrupteur et de l'état du conducteur, et que le circuit de déclenchement (8) convertit en des impulsions de durées différentes correspondantes, des secondes valeurs de tension qui sont dérivées des premières valeurs différentes de tension du dispositif à valeur-limite.

2. Dispositif selon la revendication 1, caractérisé par le fait que le dispositif à valeur-limite comporte deux diodes Zener (4, 5) montées en série par rapport au générateur, une première (4) desdites diodes Zener formant un circuit série avec le commutateur réalisé sous la forme d'un interrupteur de rupture (3b) ou de fermeture (3a), et la seconde (5) des diodes Zener shuntant l'interrupteur avec la même tension Zener que celle de ladite première diode Zener (14).

3. Dispositif selon la revendication 1, caractérisé par le fait que le dispositif à valeur-limite comporte deux diodes Zener (4, 6) une première (4) de ces diodes Zener formant, avec le commutateur réalisé sous la forme d'un interrupteur de rupture (3b) ou de fermeture (3a), un circuit série, et la seconde (6) de ces diodes Zener étant portée à une tension Zener supérieure à celle de ladite première diode Zener (4) du circuit série.

4. Dispositif selon la revendication 1, caractérisé par le fait que le dispositif à valeur de seuil comporte deux diodes Zener (4, 6) et que le commutateur est réalisé sous la forme d'un interrupteur inverseur (3c), et formant, dans une position de commutation, un circuit série avec ladite première diode Zener (6) et, dans l'autre position de commutation, un circuit série avec ladite seconde diode Zener (4), la réalisation étant telle que la tension Zener de la diode Zener (6) qui est disposée dans la voie conductrice de l'interrupteur-inverseur (3c) étant supérieure à la tension Zener de la diode Zener (4) qui est disposée dans l'autre piste conductrice.

5. Dispositif selon l'une des revendications 3 ou 4, caractérisé par le fait qu'en parallèle sur le générateur sont reliés deux circuits séries parallèles dont chacun est constitué par une diode Zener supplémentaire (11, 14) et par une résistance (10, 13) sur chacune desquelles est monté en parallèle un circuit de déclenchement supplémentaire (9, 12) et la tension Zener de l'une (11) des diodes Zener supplémentaires de l'un des circuits série supplémentaires correspond à la tension Zener de ladite première diode Zener (4) du circuit à valeur-limite, alors que la tension Zener de l'autre diode Zener supplémentaire (14) de l'autre circuit série supplémentaire correspond à la tension Zener de ladite seconde diode Zener (6) du dispositif à valeur de seuil.

FIG 1

FIG 2

FIG 3

FIG 4

FIG 5